(19) Europäisches Patentamt

European Patent Office

Office européen des brevets

(11) **EP 4 624 954 A1**

(12) **EUROPÄISCHE PATENTANMELDUNG**

(43) Veröffentlichungstag:
**01.10.2025 Patentblatt 2025/40**

(21) Anmeldenummer: **24167198.1**

(22) Anmeldetag: **28.03.2024**

(51) Internationale Patentklassifikation (IPC):
***G01R 31/367*** (2019.01) ***G01R 31/385*** (2019.01)

(52) Gemeinsame Patentklassifikation (CPC):
**G01R 31/367; G01R 31/385;** G01R 31/389

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**
Benannte Erstreckungsstaaten:
**BA**
Benannte Validierungsstaaten:
**GE KH MA MD TN**

(71) Anmelder: **Siemens Aktiengesellschaft**
**80333 München (DE)**

(72) Erfinder:
• **Katzer, Felix**
**90763 Fürth (DE)**

• **Arzberger, Arno**
**96135 Stegaurach (DE)**
• **Fischer, Michael**
**91320 Ebermannstadt (DE)**
• **Radinger, Hannes**
**90459 Nürnberg (DE)**
• **Winterstein, Heiko**
**91325 Adelsdorf (DE)**

(74) Vertreter: **Siemens Patent Attorneys**
**Postfach 22 16 34**
**80506 München (DE)**

(54) **VERFAHREN ZUM BESTIMMEN ZUMINDEST EINER SPEZIFISCHEN TESTSPANNUNG FÜR EINE BATTERIEZELLE, COMPUTERPROGRAMMPRODUKT, LESBARES SPEICHERMEDIUM SOWIE MESSVORRICHTUNG**

(57) Die Erfindung betrifft ein Verfahren zum Bestimmen zumindest einer spezifischen Testspannung ($V_{max}$, $V_{min}$) für eine Batteriezelle (12) mittels einer Messvorrichtung (10), mit den Schritten: Vorgeben einer Referenzeigenschaft einer Referenzbatteriezelle (20) mittels einer elektronischen Recheneinrichtung (14) der Messvorrichtung (10); Beaufschlagen der Batteriezelle (12) mit einem Pulstest mittels der Messvorrichtung (10); Bestimmen einer charakterisierenden Eigenschaft in Abhängigkeit von dem Pulstest mittels der elektronischen Recheneinrichtung (14); Vergleichen der Referenzeigenschaft mit der bestimmten charakterisierenden Eigenschaft mittels der elektronischen Recheneinrichtung (14); und Adaptieren einer Referenztestspannung ($V_{max,\ Ref}$), $V_{min,\ Ref}$) für die Referenzbatteriezelle (209 zur spezifischen Testspannung ($V_{max}$, $V_{min}$) in Abhängigkeit von dem Vergleich mittels der elektronischen Recheneinrichtung (14). Ferner betrifft die Erfindung ein Computerprogramm, ein computerlesbares Speichermedium sowie eine Messvorrichtung (10).

FIG 2

EP 4 624 954 A1

**Beschreibung**

Die nachfolgende Erfindung betrifft ein Verfahren zum Bestimmen zumindest einer spezifischen Testspannung für eine Batteriezelle mittels einer Messvorrichtung gemäß dem geltenden Patentanspruch 1. Fernern betrifft die Erfindung ein entsprechendes Computerprogrammprodukt, ein entsprechendes computerlesbares Speichermedium sowie eine entsprechende Messvorrichtung.

Batteriezellen lassen sich durch verschiedene Kenngrößen charakterisieren, die je nach Zelltyp, Betriebsbedingungen und Produktionsqualität jedoch deutliche Unterschiede aufweisen können. Zwei in der Praxis wichtige Kenngrößen sind dabei die Lebensdauer und die Selbstentladungsrate. Die Lebensdauer ergibt sich aus der Zellalterung, die im Wesentlichen den irreversiblen Verlust der nutzbaren Kapazität in Betriebszyklen und Zeit beschreibt. Die Selbstentladungsrate beschreibt den reversiblen Kapazitätsverlust über die Zeit. Beiden Kenngrößen ist gemein, dass sie im Normalfall nur über größere Zeitskalen zu messbaren Änderungen führen. Für praktische Untersuchungen und Bewertungen von Batteriezellen ist es hingegen wichtig, während möglichst kurzer Zeit Tests durchzuführen, welche relevante Aussagen über Kenngrößen liefern können. Aktuell werden die Zellen allerdings etwa eine Woche gelagert, um Selbstentladung anhand von Messungen vor beziehungsweise nach der Lagerung zu bestimmen. Es werden daher Methoden zur Bestimmung der Selbstentladung innerhalb von wenigen Stunden benötigt, welche dieses Vorgehen ersetzen können.

Um die Testdauer von Lebensdauer- und Selbstentladungsmessungen zu verkürzen, wird deswegen einerseits auf beschleunigte Tests zurückgegriffen, die bei höheren Temperaturen und gegebenenfalls höheren Stromstärken durchgeführt werden und so eine beschleunigte Alterung, bzw. eine Konditionierung der Zelle zur Messung der Selbstentladung zu provozieren. Allerdings stellen diese Testbedingungen dann nicht das Verhalten der Zellen unter relevanten Betriebsbedingungen dar, welches durch diese Tests beschrieben werden soll. Darüber hinaus verschlechtert sich die Energieeffizienz der Zellproduktion durch die Verwendung von hohen Temperaturen und Strömen. Aufgrund dessen, sowie der Veränderung der Batteriezellen durch diese Tests, eignet sich dieses Verfahren daher nur als stichprobenartiger Test in der Produktion und nicht zur Prüfung aller produzierten Zellen.

Andere Verfahren fokussieren sich daher auf eine erhöhte Genauigkeit in den Testmessungen, um kleine Änderungen bereits auf kurzen Zeitskalen zu quantifizieren. Im Speziellen kann hier die High Precision Coulometry (HPC)-Methode genannt werden, bei der aus der Batteriezelle entnommene beziehungsweise in ihr gespeicherte Ladungsmengen sehr genau gemessen werden. Das HPC-Verfahren misst insbesondere die genauen Ladungsmengen während der einzelnen Lade- und Entladeschritte. Damit lassen sich sowohl die Coulombic Effeciency (CE) als auch kleine Kapazitätsverluste innerhalb von wenigen Zyklen genau bestimmen. Hieraus wiederum ergeben sich beispielsweise Aussagen dann über die Selbstentladungsrate und die Lebensdauer einer Batteriezelle.

Aufgabe der vorliegenden Erfindung ist es, ein Verfahren, ein Computerprogrammprodukt, ein computerlesbares Speichermedium sowie eine Messvorrichtung zu schaffen, womit eine spezifische Testspannung für eine Batteriezelle bestimmt werden kann.

Diese Aufgabe wird durch ein Verfahren, ein Computerprogrammprodukt, ein computerlesbares Speichermedium sowie eine Messvorrichtung gemäß den unabhängigen Patentansprüchen gelöst. Vorteilhafte Ausgestaltungsformen sind in den Unteransprüchen angegeben.

Ein Aspekt der Erfindung betrifft ein Verfahren zum Bestimmen zumindest einer spezifischen Testspannung für eine Batteriezelle mittels einer Messvorrichtung. Es wird eine Referenzeigenschaft einer Referenzbatteriezelle mittels einer elektronischen Recheneinrichtung vorgegeben. Es erfolgt das Beaufschlagen der Batteriezelle mit einem Pulstest mittels der Messvorrichtung. Es wird eine charakterisierende Eigenschaft in Abhängigkeit von dem Pulstest mittels der elektronischen Recheneinrichtung bestimmt. Die Referenzeigenschaft wird mit der bestimmten charakteristischen Eigenschaft mittels der elektronischen Recheneinrichtung verglichen und es erfolgt ein Adaptieren einer Referenztestspannung für die Referenzbatteriezelle zur spezifischen Testspannung in Abhängigkeit von dem Vergleich mittels der elektronischen Recheneinrichtung.

Insbesondere kann somit einem vorgelagerten HPC-Verfahren ein Pulstest durchgeführt werden, mit dessen Hilfe der zellindividuelle Widerstand bestimmt werden kann.

Insbesondere besteht somit der wesentliche Unterschied der Erfindung zum Stand der Technik, dass zellindividuelle Widerstände bei der Methode berücksichtigt werden. Es ist völlig normal, dass die Batteriezellen einer Charge, insbesondere der sogenannten Produktionseinheit, Variationen des Widerstands von bis zu +/- 10 % zeigen. Diese Variationen können nun berücksichtigt werden, wodurch der Betriebsbereich aller getesteten Batteriezellen identisch ist im HPC-Verfahren und die Ergebnisse verschiedener Zellen besser miteinander verglichen werden können.

Beim Stand der Technik führen Zellvariationen und Messfehler der Temperatur zu einer fehlerhaften Einschätzung einer entsprechenden Überspannung für das Durchführen eines HPC-Verfahrens. Mithilfe des vorgeschlagenen Verfahrens können zum einen zellindividuelle Widerstände nun berücksichtigt werden und zum anderen werden auch Temperatureffekte ebenfalls mitberücksichtigt werden. Somit kann online auf geringste Änderungen der Betriebsbedingungen reagiert werden und die Präzision der Qualitätsverfahren somit entscheidend erhöht werden. Insbesondere kann somit auf eine vorgelagerte Einstellung eines sogenannten Look-Up-Tables, insbesondere bezüglich von Ladewiderständen und Entladewiderständen, insbesondere temperaturspezifisch, verzichtet werden, was entsprechend viel Zeit einsparen kann.

Insbesondere ist das Verfahren vorteilhaft, da die relevante Messung der Stromstärke dazu führt, dass es zu kinetischen Effekten innerhalb der Batteriezelle kommt, wodurch die an der Batteriezelle messbare Spannung nicht mehr der tatsächlichen Ruhespannung (Leerlaufspannung) entspricht. Konkret werden dabei Messungen für elektrische Parameter in Abhängigkeit von der Temperatur durchgeführt und beispielsweise ein Widerstand der Batteriezelle unter den aktuellen Testbedingungen zu ermitteln. Aus diesem Innenwiderstand ergibt sich dann die zu erwartende Überspannung ($\eta$), also der Unterschied zwischen gemessener Spannung und der Leerlaufspannung.

$$V = OCV + \eta = OCV + R*I$$

Entsprechend kann nun zu einem um die Überspannung höheren bzw. im späteren Verfahren auch tieferliegender Spannungswert geladen bzw. entladen werden, sodass die Leerlaufspannungen bzw. Ruhespannungen weiterhin den entsprechenden Zielwert erreichen.

Die Ruhespannung ist jedoch nicht explizit messbar und die Überspannung ist von vielen Faktoren abhängig. Wesentlichen Einfluss hat dabei die Temperatur. Außerdem gibt es eine starke Variation des Innenwiderstandes zwischen den Batteriezellen, sogar, wenn diese aus derselben Charge entspringen.

Das technische Problem ist somit, dass die Methode eine sehr präzise Ansteuerung der gewünschten Leerlaufspannung benötigt. Hierfür müssen die entsprechenden Überspannungen möglichst korrekt berücksichtig werden. Diese hängen jedoch von vielen Faktoren ab, die nur bedingt messbar sind.

Gemäß einer vorteilhaften Ausgestaltungsform wird die Batteriezelle mit der Testspannung zum Bestimmen einer spezifischen Eigenschaft beaufschlagt. Insbesondere erfolgt das Beaufschlagen der Testspannung nach dem Bestimmen der spezifischen Testspannung. Die Testspannung kann dann beispielsweise als Ladespannung bzw. als Entladespannung auf die Batteriezelle beaufschlagt werden. Somit können entsprechende Testverfahren durchgeführt werden, um spezifische Eigenschaften der Batteriezelle bestimmen zu können. Beispielsweise kann eine Selbstentladung und / oder Lebensdauer der Batteriezelle zuverlässig bestimmt werden.

Weiterhin vorteilhaft ist, wenn zumindest eine Ladespannung als Testspannung und / oder eine Entladespannung als Testspannung für die Batteriezelle bestimmt wird. Insbesondere kann somit in einem nachgelagerten Verfahren die Batteriezelle zuerst mit der Testspannung geladen werden und dann mit einer entsprechenden Entladespannung entladen werden. Es kann spezifisch die Testspannung zum Laden und spezifisch die Testspannung zum Entladen auf Basis des Verfahrens bestimmt werden. Somit kann hochpräzise eine spezifische Eigenschaft der Batteriezelle bestimmt werden.

Es hat sich dabei weiterhin als vorteilhaft erwiesen, wenn als charakterisierende Eigenschaft ein Diffusionswiderstand beim Laden zum Bestimmen der Ladespannung bestimmt wird und / oder ein Diffusionswiderstand beim Entladen zum Bestimmen der Entladespannung bestimmt wird. Insbesondere handelt es sich dabei im Wesentlichen um einen Gleichstrom-Widerstand während des Ladevorgangs und des Entladevorgangs. Insbesondere handelt es sich hierbei um entsprechende Ohmsche Widerstände. Insbesondere kann somit das Diffusionsverhalten von elektrochemischen Systemen charakterisiert werden, welches wiederum für eine entsprechende Überspannung ($\eta$) entscheidend ist. Im Vorfeld der eigentlichen HPC-Messung wird somit der Pulstest ebenfalls für die Referenzzelle durchgeführt und die Widerstandsparameter entsprechend gespeichert. Die Abweichungen der Widerstände von der Referenzzelle werden dann entsprechend der folgenden Gleichung für die individuelle Zelle berücksichtigt.

$$R_{ch} = R_{ch,Ref} * (R_{ch,30s} / R_{ch,30s,Ref})$$

$$R_{dch} = R_{dch,Ref} * (R_{dch,30s} / R_{dch,30s,Ref})$$

Mit $R_{ch}$ als Widerstand der Batteriezelle beim Laden, $R_{dch}$ als Widerstand der Batteriezelle beim Entladen, $R_{ch,Ref}$ $R_{ch}$ als Widerstand der Referenzbatteriezelle beim Laden, $R_{dch,Ref}$ als Widerstand der Referenzbatteriezelle beim Entladen, und wobei 30s den jeweiligen Widerständen bei dem Pulstest, insbesondere bei einem 30 Sekunden Pulstest, entspricht.

Es hat sich weiter als vorteilhaft erwiesen, wenn der Pulstest auf Basis einer galavanostatischen intermittierenden Titrationstechnik durchgeführt wird. Dabei handelt es sich insbesondere um die sogenannte GITT-Methode. Hierbei handelt es sich um eine Messtechnik, mit der thermodynamische und kinetische Parameter, insbesondere die entsprechenden Diffusionskoeffizienten der Batteriezelle, bestimmt werden können. Die Messmethode ist dabei aus einer Abfolge von Stromimpulsen, denen jeweils eine Relaxationszeit folgt, in der kein Strom durch die Batteriezelle fließt, ausgebildet. Der Strom ist beim Laden positiv und beim Entladen entsprechend negativ. Insbesondere kann beispielsweise ein entsprechender Lade- und Entladepuls mit anschließender Relaxation entsprechend durchgeführt werden, um dann die DC-Widerstände zu bestimmen, was insbesondere auf der Basis der vorgeschlagenen GITT-Methode sehr vorteilhaft durchgeführt werden kann.

Es hat sich weiterhin als vorteilhaft erwiesen, wenn nach dem Bestimmen der Testspannung ein Hochpräzisionscoulometrie-Verfahren durchgeführt wird. Dabei handelt es sich insbesondere um das bereits erwähnte High Precision Coulometry (HPC)-Verfahren. Das HPC-Verfahren misst die genauen Ladungsmengen während der einzelnen Lade- und Entladeschritte. Insbesondere verfolgt dabei das HPC-Verfahren entsprechende Testzyklen, bei denen die Batteriezelle zwischen zwei definierten Zuständen, insbesondere beschrieben durch eine Maximalspannung und eine Minimalspannung mit einer definierten Stromstärke zyklisiert wird. Die Dauer der einzelnen Lade- und Entladeschritte tcharge und tdischarge hängen dabei von den Eigenschaften der getesteten Batteriezelle ab. Auf Basis des HPC-Verfahrens kann somit hochpräzise die Coulombic Effeciency entsprechend bestimmt werden und auf Basis dessen wiederum zuverlässig die charakterisierende Eingabe der Batteriezelle bestimmt werden.

Ferner hat es sich als vorteilhaft erwiesen, wenn das Verfahren über eine vorgegebene Zeitspanne durchgeführt wird. Insbesondere kann die Zeitspanne beispielswiese 30 Sekunden betragen. Die Zeitspanne ist dabei insbesondere dem HPC-Verfahren vorgelagert. Somit kann auf schnelle Art und Weise die Testspannung bestimmt werden.

Es hat sich weiter als vorteilhaft erwiesen, wenn die Zeitspannen zumindest in zwei Zeitfenster unterteilt wird und eine jeweilige charakterisierende Eigenschaft von dem jeweiligen Zeitfenster bestimmt wird und in Abhängigkeit davon die Testspannung bestimmt wird. Insbesondere ist somit eine Trennung des beispielsweise 30-Sekunden-Widerstandes in mehrere Widerstände mit unterschiedlichen Zeitkonstanten vorgesehen. Dies hat den Vorteil, dass die elektrochemischen Prozesse besser getrennt werden können. Damit ist eine präzisere Berechnung des Diffusionswiderstands möglich, welche nun wieder für die entsprechende Überspannung ($\eta$) entscheidend ist.

In einer weiteren Ausgestaltungsform ist vorgesehen, dass mittels des Verfahrens eine benötigte Überspannung zwischen einer maximalen Ladespannung und einer maximalen Leerlaufspannung bestimmt wird und auf Basis der Überspannung die Testspannung bestimmt wird. Somit ist ermöglicht, dass die Batteriezellen immer auf die gleiche Leerlaufspannung geladen werden, da die Überspannung zuverlässig bestimmt werden kann. Die Überspannung ist insbesondere definiert durch die Leerlaufspannung und der entsprechend benötigten Ladespannung. Die maximale Ladespannung entspricht dabei insbesondere der vorgegebenen Testspannung. Insbesondere ist die Überspannung für das nachgelagerte HPC-Verfahren notwendig.

Weiter vorteilhaft ist, wenn nach dem Pulstest eine Relaxation der Batteriezelle durchgeführt wird. Somit kann ein Relaxieren der Batteriezelle realisiert werden, wobei auf Basis des Pulstestes und der Relaxation zuverlässig die entsprechenden Diffusionswiderstände bestimmt werden können. Somit kann zuverlässig die Testspannung bestimmt werden.

Es hat sich weiterhin als vorteilhaft erwiesen, wenn mittels der Testspannung eine Lebensdauer der Batteriezelle und / oder eine Selbstentladungsrate der Batteriezelle bestimmt wird. Insbesondere kann mittels des HPC-Verfahrens die Lebensdauer der Batteriezelle und / oder Selbstentladung der Batteriezelle bestimmt werden. Somit können wesentliche charakterisierende Eigenschaften bzw. spezifische Eigenschaften der Batteriezelle bestimmt werden, welche insbesondere für die Qualität der Batteriezelle entscheidend sind.. Insbesondere Batteriezellen weisen die so genannte Selbstentladungsrate auf, welche dazu führt, dass ohne äußeren Einfluss dennoch eine Entladung der Batteriezelle aufzufinden ist. Diese Selbstentladungsrate ist wiederum eine spezifische charakterisierende Eigenschaft einer spezifischen Batteriezelle. Diese dient insbesondere zur Qualitätsbestimmung der Batteriezelle. Es ist nun möglich, dass die Selbstentladungsrate zuverlässig und hochpräzise auf Basis des vorgestellten Verfahrens bestimmt werden kann. Insbesondere die Lebensdauer der Batteriezelle ist ebenfalls eine wichtige Kenngröße einer spezifischen Batteriezelle und dient insbesondere zum Bestimmen der Qualität der Batteriezelle. Dabei kann zusätzlich oder ergänzend als die charakterisierende Eigenschaft ein Kapazitätsverlust pro Zyklus der Batteriezelle bestimmt werden. Auf Basis des Kapazitätsverlusts können beispielsweise die Lebensdauer und/oder die Selbstentladungsrate bestimmt werden. Die Bestimmung des Kapazitätsverlusts benötigt noch mindestens eine weitere Ladungsmenge eines folgenden Zyklus. Somit werden mehrere Qcharge (zugeführte Ladungsmenge) und Qdischarge (entnommene Ladungsmenge) aus mehreren Zyklen benötigt, da hier beispielsweise der Unterschied von Qdischarge aus zwei aufeinanderfolgenden Zyklen verglichen wird. Somit kann mittels des vorgeschlagenen Verfahrens die Lebensdauer der Batteriezelle bestimmt werden.

Bei dem vorgestellten Verfahren handelt es sich im Wesentlichen um ein computerimplementiertes Verfahren. Daher trifft ein weiterer Aspekt der Erfindung, ein Computerprogrammprodukt mit Programmcodemitteln, welcher eine elektronische Rechnung zu veranlassen, wenn die Programmcodemittel von der elektronischen Recheneinrichtung abgearbeitet werden, ein Verfahren nach dem vorhergehenden Aspekt durchzuführen.

Daher betrifft weiterhin die Erfindung auch ein computerlesbares Speichermedium mit einem Computerprogrammcode nach dem vorhergehenden Aspekt.

Ferner betrifft die Erfindung auch eine Messvorrichtung zum Bestimmen zumindest einer spezifischen Testspannung für eine Batteriezelle, mit zumindest einer elektronischen Recheneinrichtung, wobei die Messvorrichtung zum Durchführen eines Verfahrens nach dem vorhergehenden Aspekt ausgebildet ist. Insbesondere wird das Verfahren mittels der Messvorrichtung durchgeführt.

Vorteilhafte Ausgestaltungsformen des Verfahrens sind als vorteilhafte Ausgestaltungsformen des Computerprogrammprodukts, des computerlesbaren Speichermediums sowie der Messvorrichtung anzusehen. Die Messvorrichtung weist hierzu gegenständliche Merkmale auf, um entsprechende Verfahrensschritte durchführen zu können.

Unter einer Recheneinheit/elektronische Recheneinrichtung kann insbesondere ein Datenverarbeitungsgerät verstanden werden, das einen Verarbeitungsschaltkreis enthält. Die Recheneinheit kann also insbesondere Daten zur Durchführung von Rechenoperationen verarbeiten. Darunter fallen gegebenenfalls auch Operationen, um indizierte Zugriffe auf eine Datenstruktur, beispielsweise eine Umsetzungstabelle, LUT (englisch: "look-up table"), durchzuführen.

Die Recheneinheit kann insbesondere einen oder mehrere Computer, einen oder mehrere Mikrocontroller und/oder einen oder mehrere integrierte Schaltkreise enthalten, beispielsweise eine oder mehrere anwendungsspezifische integrierte Schaltungen, ASIC (englisch: "application-specific integrated circuit"), eines oder mehrere feldprogrammierbare Gate-Arrays, FPGA, und/oder eines oder mehrere Einchipsysteme, SoC (englisch: "system on a chip"). Die Recheneinheit kann auch einen oder mehrere Prozessoren, beispielsweise einen oder mehrere Mikroprozessoren, eine oder mehrere zentrale Prozessoreinheiten, CPU (englisch: "central processing unit"), eine oder mehrere Grafikprozessoreinheiten, GPU (englisch: "graphics processing unit") und/oder einen oder mehrere Signalprozessoren, insbesondere einen oder mehrere Digitalsignalprozessoren, DSP, enthalten. Die Recheneinheit kann auch einen physischen oder einen virtuellen Verbund von Computern oder sonstigen der genannten Einheiten beinhalten.

In verschiedenen Ausführungsbeispielen beinhaltet die Recheneinheit eine oder mehrere Hardware- und/oder Softwareschnittstellen und/oder eine oder mehrere Speichereinheiten.

Eine Speichereinheit kann als flüchtiger Datenspeicher, beispielsweise als dynamischer Speicher mit wahlfreiem Zugriff, DRAM (englisch: "dynamic random access memory") oder statischer Speicher mit wahlfreiem Zugriff, SRAM (englisch: "static random access memory"), oder als nicht-flüchtiger Datenspeicher, beispielsweise als Festwertspeicher, ROM (englisch: "read-only memory"), als programmierbarer Festwertspeicher, PROM (englisch: "programmable read-only memory"), als löschbarer programmierbarer Festwertspeicher, EPROM (englisch: "erasable programmable read-only memory"), als elektrisch löschbarer programmierbarer Festwertspeicher, EEPROM (englisch: "electrically erasable programmable read-only memory"), als Flash-Speicher oder Flash-EEPROM, als ferroelektrischer Speicher mit wahlfreiem Zugriff, FRAM (englisch: "ferroelectric random access memory"), als magnetoresistiver Speicher mit wahlfreiem Zugriff, MRAM (englisch: "magnetoresistive random access memory") oder als Phasenänderungsspeicher mit wahlfreiem Zugriff, PCRAM (englisch: "phase-change random access memory"), ausgestaltet sein.

Für Anwendungsfälle oder Anwendungssituationen, die sich bei einem erfindungsgemäßen Verfahren ergeben können und die hierin nicht explizit beschrieben sind, kann vorgesehen sein, dass gemäß dem Verfahren eine Fehlermeldung und/oder eine Aufforderung zur Eingabe einer Nutzerrückmeldung ausgegeben und/oder eine Standardeinstellung und/oder ein vorbestimmter Initialzustand eingestellt wird.

Unabhängig vom grammatikalischen Geschlecht eines bestimmten Begriffes sind Personen mit männlicher, weiblicher oder anderer Geschlechteridentität mit umfasst.

Weitere Merkmale und Merkmalskombinationen der Erfindung ergeben sich aus den Figuren und deren Beschreibung sowie aus den Ansprüchen. Insbesondere müssen weitere Ausführungsformen der Erfindung nicht unbedingt alle Merkmale eines der Ansprüche enthalten. Weitere Ausführungsformen der Erfindungen können Merkmale oder Merkmalskombinationen aufweisen, die nicht in den Ansprüchen genannt sind.

Dabei zeigen:

Figur 1    ein schematisches Blockschaltbild gemäß einer Messvorrichtung; und

Figur 2    ein schematisches Zeit-Spannungsdiagramm für einen Zyklus einer Batteriezelle in einem nachgelagerten HPC-Verfahren.

Die Erfindung wird im Folgenden anhand konkreter Ausführungsbeispiele und zugehöriger schematischer Zeichnungen näher erläutert. In den Figuren können gleiche oder funktionsgleiche Elemente mit denselben Bezugszeichen versehen sein. Die Beschreibung gleicher oder funktionsgleicher Elemente wird gegebenenfalls nicht notwendigerweise bezüglich verschiedener Figuren wiederholt.

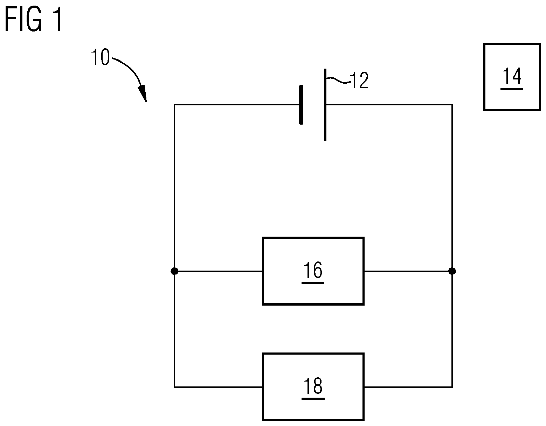

Figur 1 zeigt ein schematisches Blockschaltbild einer Ausführungsform einer Messvorrichtung 10. Die Messvorrichtung 10 ist zum Bestimmen einer Testspannung $V_{max}$, $V_{min}$ für eine Batteriezelle 12 ausgebildet. Hierzu weist die Messvorrichtung 10 zumindest eine elektronische Recheneinrichtung 14 auf. Ferner weist die Messvorrichtung 10 eine Testeinrichtung 16 auf, um die entsprechende Testspannung $V_{max}$, $V_{min}$ auf Basis eines Pulstests zu bestimmen und die Batterizelle 12 damit zu beaufschlagen. Des Weiteren zeigt die Figur 1 insbesondere noch einen Zyklisierer 18, welcher insbesondere für ein nachgelagertes Hochpräzisionscoulometrie-Verfahren benötigt wird.

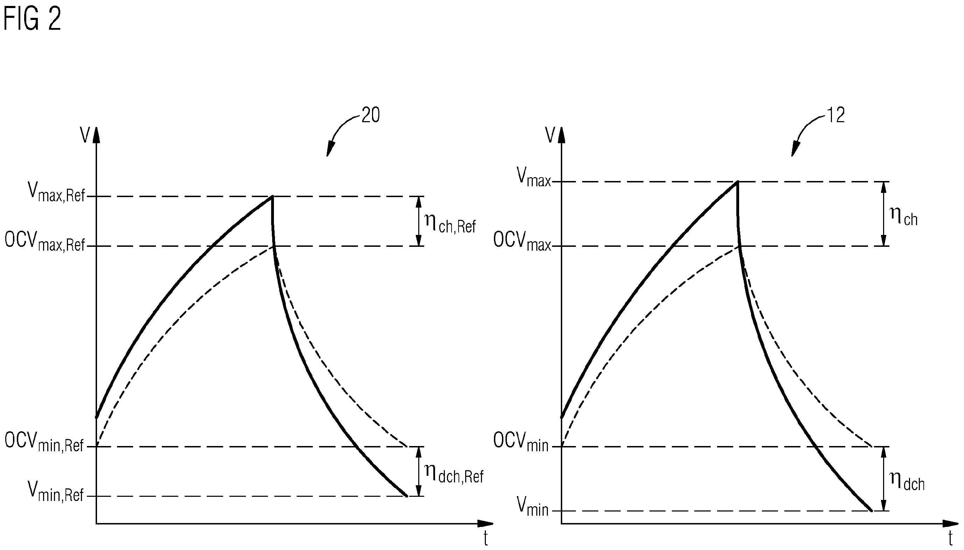

Figur 2 zeigt ein schematisches Zeit (t)-Spannungsdiagramme (V). Auf der linken Seite ist insbesondere ein Diagramm für eine Referenzbatteriezelle 20 gezeigt und auf der rechten Seite ist das Zeit-Spannungsdiagramm für die Batteriezelle 12 gezeigt.

Erfindungsgemäß ist vorgesehen, dass eine Referenzeigenschaft der Referenzbatteriezelle 20 mittels der elektronischen Recheneinrichtung 14 vorgegeben wird. Es erfolgt das Beaufschlagen der Batteriezelle 12 mit dem Pulstest mittels der Messvorrichtung 10. Es wird die charakterisierende Eigenschaft in Abhängigkeit von dem Pulstest mittels der elektronischen Recheneinrichtung 14 bestimmt. Es erfolgt das Vergleichen der Referenzeigenschaft mit der bestimmten charakterisierenden Eigenschaft mittels der elektronischen Recheneinrichtung 14 und das Adaptieren einer Referenztestspannung $V_{max\,Ref}$, $V_{min\,Ref}$ für die Referenzbatteriezelle 20 zur spezifischen Testspannung $V_{max}$, $V_{min}$ in Abhängigkeit von dem Vergleich mittels der elektronischen Recheneinrichtung 14.

Dabei wird die Batteriezelle 12 insbesondere mit der Testspannung $V_{max}$, $V_{min}$ zum Bestimmen einer spezifischen Eigenschaft 12 beaufschlagt. Ferner wird zumindest eine Ladespannung $V_{max}$ als Testspannung $V_{max}$, $V_{min}$ und / oder eine Entladespannung $V_{min}$ als Testspannung $V_{max}$, $V_{min}$ für die Batteriezelle 12 bestimmt. Weiterhin kann vorgesehen sein, dass als charakterisierende Eigenschaft ein Diffusionswiderstand $R_{ch}$ beim Laden zum Bestimmen der Ladespannung $V_{max}$ bestimmt wird und / oder ein Diffusionswiderstand $R_{dch}$ beim Entladen zum Bestimmen der Entladespannung $V_{min}$ bestimmt wird.

Insbesondere kann weiterhin vorgesehen sein, dass der Pulstest auf Basis einer galvanostatischen intermittierenden Titrationstechnik durchgeführt wird. Ferner kann vorgesehen sein, wie bereits erwähnt, dass nach dem Bestimmen der Testspannung $V_{max}$, $V_{min}$ ein Hochpräzisionscoulometrie-Verfahren durchgeführt wird. Ferner kann vorgesehen sein, dass das Verfahren über eine vorgegebene Zeitspanne durchgeführt wird. Dabei kann die Zeitspanne in zumindest zwei Zeitfenster unterteilt werden und eine jeweilige charakterisierende Eigenschaft für ein jeweiliges Zeitfenster bestimmt werden und in Abhängigkeit davon die Testspannung $V_{max}$, $V_{min}$ bestimmt werden.

Ferner kann vorgesehen sein, dass mittels des Verfahrens eine benötigte Überspannung $\eta_{ch}$ zwischen der maximalen Ladespannung $V_{max}$ und einer maximalen Leerlaufspannung $OCV_{max}$ bestimmt wird und auf Basis der Überspannung $\eta_{ch}$ die Testspannung $V_{max}$ bestimmt wird. Dies kann selbstverständlich auch für die Entladespannung bestimmt werden, wobei zwischen einer minimalen Ladespannung $V_{min}$ und einer minimalen Leerlaufspannung $OCV_{min}$ dann wiederum die weitere Überspannung $\eta_{dch}$ bestimmt werden kann.

Des Weiteren kann vorgesehen sein, dass nach dem Pulstest eine Relaxation der Batteriezelle 12 durchgeführt wird. Ferner kann mittels der Testspannung $V_{max}$, $V_{min}$ eine Lebensdauer der Batteriezelle 12 und / oder Selbstentladung der Batteriezelle 12 bestimmt werden.

Insbesondere ist somit vorgesehen, dass zur Ergänzung der HPC-Messung nach dem Stand der Technik zu Beginn der Messung ein Pulstest durchgeführt wird, mit dessen Hilfe der zellindividuelle Widerstand

$R_{ch}$ und $R_{dch}$ bestimmt werden kann. Konkret kann ein 30-Sekunden Lade- und Entladepuls mit anschließender Relaxation durchgeführt werden, um den DC-Widerstand nach 30 Sekunden $R_{ch,\,30s}$ und $R_{dch,\,30s}$ mithilfe der GITT-Methode (Galvano static intermittent tatration Technic) zu bestimmen. Mit dieser Methode kann das Diffusionsverhalten von elektrochemischen Systemen charakterisiert werden, welches für die Überspannung ($\eta$) entscheidend ist. Im Vorfeld der eigentlichen HPC-Messung wird dieser 30 Sekunden mittels Pulstest ebenfalls für die Referenzbatteriezelle 20 durchgeführt und die Widerstandsparameter $R_{ch,30s,Ref}$ und $R_{dch,30s,Ref}$ gespeichert.

Abweichungen der Widerstände $R_{ch,30s}$ und $R_{dch,30s}$ von der Referenzbatteriezelle 20 werden dann entsprechend folgender Gleichung für die individuelle Batteriezelle 12 berücksichtigt:

$$R_{ch} = R_{ch,\,Ref} \times (R_{ch,\,30s} : R_{ch,\,30s,\,Ref})$$

$$R_{dch} = R_{dch,\,Ref} \times (R_{dch,\,30s} : R_{dch,\,30s,\,Ref}).$$

Aus der Anpassung ergeben sich entsprechend der Figur 2 zellindividuelle Lade-Entladeschlussspannungen $V_{min}$ und $V_{max}$ und ein konstanter OCV-Betriebsbereich. Die Spannungsgrenzen der Referenzzelle und der individuellen Batteriezelle 12 (i) sind demnach nicht mehr konstant:

$$V\_(max,\,Ref) \neq V\_(max,\,i)$$

$$V\_(min\,Ref) \neq V\_(min,\,i)$$

Die Figur 2 zeigt aber insbesondere den Unterschied, dass die zellindividuellen Widerstände und Überspannungen ($\eta$) berücksichtigt werden und somit der identische OCV-Bereich genutzt wird.

Dabei ist es, wie bereits erwähnt, auch möglich, den 30-Sekunden-Widerstand in mehrere Widerstände mit unterschiedlichen Zeitkonstanten aufzuteilen. Dies hat den Vorteil, dass die elektrochemischen Prozesse besser getrennt werden können. Damit wird eine präzisere Berechnung des Diffusionswiderstandes möglich, welcher für die Bestimmung der Überspannungen $\eta_{ch}$, $\eta_{dch}$ entscheidend ist.

Bezugszeichenliste

| | |
|---|---|
| 10 | Messvorrichtung |
| 12 | Batteriezelle |
| 14 | elektronische Recheneinrichtung |
| 16 | Testeinrichtung |
| 18 | Zyklisierer |
| 20 | Referenzbatteriezelle |

| | |
|---|---|
| $V_{max, Ref}$ | Maximale Ladespannung |
| $V_{min, Ref}$ | Minimale Ladespannung |
| $OCV_{max, Ref}$ | Maximale Leerlaufspannung |
| $OCV_{min, Ref}$ | Minimale Leerlaufspannung |
| $\eta_{ch, Ref}$ | Überspannung |
| $\eta_{dch, Ref}$ | Weitere Überspannung |
| $V_{max}$ | Maximale Ladespannung |
| $V_{min}$ | Minimale Ladespannung |
| $OCV_{max}$ | Maximale Leerlaufspannung |
| $OCV_{min}$ | Minimale Leerlaufspannung |
| $\eta_{ch}$ | Überspannung |
| $\eta_{dch}$ | Weitere Überspannung |
| V | Spannung |
| t | Zeit |

**Patentansprüche**

1. Verfahren zum Bestimmen zumindest einer spezifischen Testspannung ($V_{max}$, $V_{min}$) für eine Batteriezelle (12) mittels einer Messvorrichtung (10), mit den Schritten:

   - Vorgeben einer Referenzeigenschaft einer Referenzbatteriezelle (20) mittels einer elektronischen Recheneinrichtung (14) der Messvorrichtung (10);
   - Beaufschlagen der Batteriezelle (12) mit einem Pulstest mittels der Messvorrichtung (10);
   - Bestimmen einer charakterisierenden Eigenschaft in Abhängigkeit von dem Pulstest mittels der elektronischen Recheneinrichtung (14);
   - Vergleichen der Referenzeigenschaft mit der bestimmten charakterisierenden Eigenschaft mittels der elektronischen Recheneinrichtung (14); und
   - Adaptieren einer Referenztestspannung ($V_{max, Ref}$), $V_{min, Ref}$) für die Referenzbatteriezelle (209 zur spezifischen Testspannung ($V_{max}$, $V_{min}$) in Abhängigkeit von dem Vergleich mittels der elektronischen Recheneinrichtung (14).

2. Verfahren nach Anspruch 1, **dadurch gekennzeichnet, dass** die Batteriezelle (12) mit der Testspannung ($V_{max}$, $V_{min}$) zum Bestimmen einer spezifischen Eigenschaft der Batteriezelle (12) beaufschlagt wird.

3. Verfahren nach Anspruch 1 oder 2, **dadurch gekennzeichnet, dass** zumindest eine Ladespannung ($V_{max}$) als Testspannung ($V_{max}$, $V_{min}$) und/oder eine Entladespannung ($V_{min}$) als Testspannung ($V_{max}$, $V_{min}$) für die Batteriezelle (12) bestimmt wird.

4. Verfahren nach Anspruch 3, **dadurch gekennzeichnet, dass** als charakterisierende Eigenschaft ein Diffusionswiderstand beim Laden zum Bestimmen der Ladespannung ($V_{max}$) bestimmt wird und/oder ein Diffusionswiderstand beim Entladen zum Bestimmen der Entladespannung ($V_{min}$) bestimmt wird.

5. Verfahren nach einem der vorhergehenden Ansprüche, **dadurch gekennzeichnet, dass** der Pulstest auf Basis einer galvanostatischen intermittierenden Titrationstechnik durchgeführt wird.

6. Verfahren nach einem der vorhergehenden Ansprüche, **dadurch gekennzeichnet, dass** nach dem Bestimmen der Testspannung ($V_{max}$, $V_{min}$) ein Hochpräzisionscoulometrie-Verfahren durchgeführt wird.

7. Verfahren nach einem der vorhergehenden Ansprüche, **dadurch gekennzeichnet, dass** das Verfahren über eine vorgegebene Zeitspanne durchgeführt wird.

8. Verfahren nach Anspruch 7, **dadurch gekennzeichnet, dass** die Zeitspanne in zumindest zwei Zeitfenster unterteilt wird und eine jeweilige charakterisierende Eigenschaft für ein jeweiliges Zeitfenster bestimmt wird und in Abhängigkeit davon die Testspannung ($V_{max}$, $V_{min}$) bestimmt wird.

9. Verfahren nach einem der vorhergehenden Ansprüche, **dadurch gekennzeichnet, dass** mittels des Verfahren eine benötigte Überspannung ($\eta_{ch}$) zwischen einer maximalen Ladespannung ($V_{max}$) und einer maximalen Leerlaufspannung ($OCV_{max}$) bestimmt wird und auf Basis der Überspannung ($\eta_{ch}$) die Testspannung ($V_{max}$, $V_{min}$) bestimmt wird.

10. Verfahren nach einem der vorhergehenden Ansprüche, **dadurch gekennzeichnet, dass** nach dem Pulstest eine Relaxation der Batteriezelle (12) durchgeführt wird.

11. Verfahren nach einem der vorhergehenden Ansprüche, **dadurch gekennzeichnet, dass** mittels der Testspannung ($V_{max}$, $V_{min}$) eine Lebensdauer der Batteriezelle (12) und/oder eine Selbstentladung der Batteriezelle (12) bestimmt wird.

12. Computerprogrammprodukt mit Programmcodemitteln, welche eine elektronische Recheneinrichtung (14) dazu veranlassen, wenn die Programmcodemittel von der elektronischen Recheneinrichtung (14) abgearbeitet werden, ein Verfahren nach einem der Ansprüche 1 bis 11 durchzuführen.

13. Computerlesbares Speichermedium mit einem Computerprogrammprodukt nach Anspruch 12.

14. Messvorrichtung (10) zum Bestimmen zumindest einer spezifischen Testspannung ($V_{max}$, $V_{min}$) für eine Batteriezelle (12), mit zumindest einer elektronischen Recheneinrichtung (14), wobei die Messvorrichtung (10) zum Durchführen eines Verfahrens nach einem der Ansprüche 1 bis 11 ausgebildet ist.

FIG 1

FIG 2

Europäisches
Patentamt

European
Patent Office

Office européen
des brevets

# EUROPÄISCHER RECHERCHENBERICHT

**Nummer der Anmeldung**

EP 24 16 7198

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | US 2020/124679 A1 (LIM JU WAN [KR] ET AL) 23. April 2020 (2020-04-23) * Absätze [0074], [0075]; Ansprüche 1,2 * ----- | 1-14 | INV. G01R31/367 G01R31/385 |
| A | EP 3 832 331 B1 (VEHICLE ENERGY JAPAN INC [JP]) 2. August 2023 (2023-08-02) * Anspruch 1 * ----- | 1-14 | |
| A | JP 2013 253857 A (CALSONIC KANSEI CORP) 19. Dezember 2013 (2013-12-19) * Absatz [0006]; Anspruch 1 * ----- | 1-14 | |
| A | JUSTON MAXIME ET AL: "Extracting the diffusion resistance and dynamic of a battery using pulse tests", JOURNAL OF ENERGY STORAGE, Bd. 57, 6. Dezember 2022 (2022-12-06), Seite 106199, XP093198519, NL ISSN: 2352-152X, DOI: 10.1016/j.est.2022.106199 * das ganze Dokument * ----- | 1-14 | **RECHERCHIERTE SACHGEBIETE (IPC)** G01R |

Der vorliegende Recherchenbericht wurde für alle Patentansprüche erstellt

| Recherchenort | Abschlußdatum der Recherche | Prüfer |
|---|---|---|
| München | 26. August 2024 | Stussi, Elisa |

**ANHANG ZUM EUROPÄISCHEN RECHERCHENBERICHT
ÜBER DIE EUROPÄISCHE PATENTANMELDUNG NR.**

EP 24 16 7198

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

26-08-2024

| Im Recherchenbericht angeführtes Patentdokument | Datum der Veröffentlichung | Mitglied(er) der Patentfamilie | Datum der Veröffentlichung |
|---|---|---|---|
| US 2020124679 A1 | 23-04-2020 | CN 111082170 A | 28-04-2020 |
| | | EP 3641096 A1 | 22-04-2020 |
| | | KR 20200044348 A | 29-04-2020 |
| | | US 2020124679 A1 | 23-04-2020 |
| EP 3832331 B1 | 02-08-2023 | CN 112912747 A | 04-06-2021 |
| | | EP 3832331 A1 | 09-06-2021 |
| | | JP 6947937 B2 | 13-10-2021 |
| | | JP WO2020026509 A1 | 08-04-2021 |
| | | US 2021311127 A1 | 07-10-2021 |
| | | WO 2020026509 A1 | 06-02-2020 |
| JP 2013253857 A | 19-12-2013 | JP 5832380 B2 | 16-12-2015 |
| | | JP 2013253857 A | 19-12-2013 |

EPO FORM P0461

Für nähere Einzelheiten zu diesem Anhang : siehe Amtsblatt des Europäischen Patentamts, Nr.12/82